(19) Europäisches Patentamt
European Patent Office
Office européen des brevets

(11) **EP 1 410 496 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**13.07.2016 Patentblatt 2016/28**

(45) Hinweis auf die Patenterteilung:
**24.11.2004 Patentblatt 2004/48**

(21) Anmeldenummer: **02750811.8**

(22) Anmeldetag: **27.06.2002**

(51) Int Cl.:
*H03D 3/00* (2006.01)        *H03C 3/40* (2006.01)
*H04L 27/00* (2006.01)

(86) Internationale Anmeldenummer:
**PCT/DE2002/002356**

(87) Internationale Veröffentlichungsnummer:
**WO 2003/013191 (13.02.2003 Gazette 2003/07)**

(54) **VERFAHREN UND VORRICHTUNG ZUR KOMPENSATION EINES PHASENFEHLERS EINES EMPFANGS- UND/ODER SENDESYSTEMS MIT I/Q-SCHNITTSTELLE**

METHOD AND DEVICE FOR COMPENSATING A PHASE ERROR IN A RECEIVER AND/OR TRANSMITTER SYSTEM WITH AN I/Q-INTERFACE

PROCÉDÉ ET DISPOSITIF POUR COMPENSER UNE ERREUR DE PHASE DE SYSTÈME DE RÉCEPTION ET/OU D'ÉMISSION À INTERFACE I & Q

(84) Benannte Vertragsstaaten:
**DE DK FI FR GB IT SE**

(30) Priorität: **25.07.2001 DE 10136071**

(43) Veröffentlichungstag der Anmeldung:
**21.04.2004 Patentblatt 2004/17**

(73) Patentinhaber: **Intel Deutschland GmbH**
**85579 Neubiberg (DE)**

(72) Erfinder: **GUNZELMANN, Bertram**
**86343 Königsbrunn (DE)**

(74) Vertreter: **Lange, Thomas et al**
**Patentanwälte**
**Lambsdorff & Lange**
**Dingolfinger Strasse 6**
**81673 München (DE)**

(56) Entgegenhaltungen:
EP-A- 0 378 719        EP-A1- 0 530 107
EP-A1- 0 731 556        EP-A1- 1 087 536
EP-B1- 0 512 748        WO-A1-96/19875
WO-A1-99/05784        DE-T2- 69 215 298
US-A- 4 843 584        US-A- 5 105 195
US-A- 5 705 949        US-A- 5 889 822

• Buchholz M. et al.: "Effects of tuner IQ imbalance on multicarrier-modulation systems", Proceedings of the Third IEEE International Caracas Conferences on Devices, Circuits and Systems, Cancun (Mexico), Seite T65-1 bis T65-6
• BRONSTEIN I.N. ET AL: 'Taschenbuch der Mathematik', Bd. 21, 1981, VERLAG HARRI DEUTSCH, FRANKFURT AM MAIN Seite 1
• TROPPER A.M. ET AL: 'Matrizenrechnung in der Elektrotechnik', 1964, BIBLIOGRAPHISCHES INSTITUT, MANNHEIM, ISBN 00001964 Seite 24
• OJANPERÄ T. ET AL: 'Wideband CDMA for Third Generation Mobile Communications', 1998, ARTECH HOUSE PUBLISHERS, BOSTON - LONDON Seiten 306 - 308
• GÖBEL J.: 'Kommunikationstechnik, Grundlagen und Anwendungen', 1999, HÜTHIG VERLAG Seite 515

**Beschreibung**

Die Erfindung betrifft ein Verfahren zur Kompensation eines Phasenfehlers in einem Empfangs- und/oder Sendesystem mit I-und Q-Signalverarbeitungszwelgen.

In Datenübertragungssystemen generell und insbesondere im Bereich des Mobilfunks werden immer höhere Datenraten angestrebt. Während die Mobilfunksysteme der zweiten Generation noch durch Datenraten im Bereich von 10kbit/s begrenzt waren, sind in Mobilfunksystemen der dritten Generation, beispielsweise UMTS (Universal Mobile Telecommunications System), Datenraten im Bereich von 2Mbit/s zu erreichen.

Eine Möglichkeit zur Erzielung höherer Datenraten besteht darin, zu höherstufigen Modulationsverfahren überzugehen. Ein Beispiel hierfür ist die Weiterentwicklung des GSM-(Global System for Mobile Communications-) Standard zum EDGE- (Enhanced Data Services for GSM Evolution-) Standard und der damit verbundene Übergang vom 2-stufigen GMSK-(Gaussian Minimum Shift Keying-) Modulationsverfahren zum 8-stufigen 8PSK-(Phase Shift-Keying-)Modulationsverfahren.

Durch den Übergang zu höherstufigen Modulationsverfahren erhöhen sich die Anforderungen an die Phasengenauigkeit der Signalverarbeitung in den Inphase-(I-) und Quadratur-(Q-) Zweigen eines Empfangs- bzw. Sendesystems. Die I- und Q-Signalzweige weisen idealerweise eine Phasenverschiebung von exakt 90° zueinander auf.

Bin Chipsatz für ein Sende- und/oder Empfangssystem des GSM/UMTS-Standards besteht üblicherweise aus einem Basisband-Chip, der für die Basisband-Signalbearbeitung und die Analogzu-Digltal- und Digital-zu-Analog-Wandlung verantwortlich ist, und einem Hochfrequenz-Chip, der empfangene Signale von der Trägerfrequenz in das Basisband bzw. zu sendende Signale vom Basisband in die Trägerfrequenz umsetzt. Die Frequenzumsetzung wird zur Erzeugung (im Falle eines Empfangssystems) bzw. zur Kombination (im Falle eines Sendesystems) der I- und Q-Signalkomponenten genutzt. Dabei kann die Schwierigkeit auftreten, dass bei dieser Umsetzung aufgrund Herstellungsoder umweltbedingter Bauteiltoleranzen die vorgeschriebene Winkeldifferenz von 90° zwischen den I- und Q-Zweigen nicht exakt eingehalten wird.

Ein Phasenfehler im Empfangssystem verursacht eine Störung des Empfangssignals, welche eine Verschlechterung der Bit-Fehlerrate bezogen auf einen vorgegebenen Signal-zu-Rausch-Abstand des empfangenen Signals zur Folge hat. Im Sendesystem verursacht ein Phasenfehler eine Verzerrung der Signalform, welche eine verminderung der spektralen Reinheit des Sendesignals zur Folge hat.

Wird ein höherstufiges Modulationsalphabet verwendet, erhöhen sich in beiden Fällen die nachteiligen Auswirkungen der genannten Effekte, weil die Anforderungen an die Winkelgenauigkeit der Signaldetektion bzw. Signalerzeugung zunehmen.

In der Schrift US 5,705,949 ist ein Regelverfahren beschrieben, bei welchem eine kontinuierliche Korrektur eines Phasenfehlers in einem Funkempfänger durchgeführt wird. Zu diesem Zweck wird der aktuelle Phasenfehler in dem Funkgerät mittels eines Detektors gemessen und ausgeregelt.

In der Schrift EP 0 378 719 ist ein Sender beschrieben, in welchem eine Phasenkorrektur eines durch Nichtlinearit&ten im Verstärker entstehenden Phasenfehlers vorgenommen wird. Die Phasenfehlerkorrektur erfolgt in Abhängigkeit von der Amplitude des Sendesignals.

Der Erfindung liegt daher die Aufgabe zugrunde, ein Verfahren anzugeben, welches es ermöglicht, in einem Empfangs- und/oder Sendesystem mit I- und Q-Signalverarbeitungszweigen mit guter Genauigkeit eine Phäsendifferenz von 90° zu gewährleisten.

Die der Erfindung zugrundeliegende Aufgabenstellung wird durch die Merkmale der unabhängigen Ansprüche gelöst.

Gemäß Anspruch 1 wird ein zuvor durch Messung ermittelter Phasenfehler $\Delta\phi$ einer In dem Sendesystem verwendeten Hochfrequenzsendestufe während der Erstmontage des Sendesystems in den digitalen Signalverarbeitungsabschnitt des Sendesystems programmiert. Während des Sendebetriebs werden durch Korrektur von I- und Q-signalkomponenten mit dem programmierten konstanten Phasenfehler $\Delta\phi$ phasenkorrigierte I-und Q-Signalkomponenten in einem digitalen Signalverarbeitungsabschnittder I-und Q-Signalverarbeicungszweige berechnet.

In entsprechender Weise wird ein zuvor durch Messung ermittelter Phasenfehler $\Delta\phi$ einer in dem Empfangssystem verwendeten Hochfrequenzempfangsstufe während der Erstmontage des Empfangssystems in den digitalen Signalverarbeitungsabschnitt des Empfangssystems programmiert. Während des Empfangsbetriebs werden durch Korrektur von I- und Q-Signalkomponenten auf dem programmierten konstanten Phasenfehler $\Delta\phi$ phasenkorrigierte I- und Q-Signalkomponenten In einem digitalen Signalverarbeitungsabschnitt der I- und Q-Signalverarbeitungszweige berechnet.

Vorzugsweise erfolgt die Berechnung der phasenkorrigierten I-und Q-Signalkomponenten gemäß

$$\begin{bmatrix} I(\Delta\phi) \\ Q(\Delta\phi) \end{bmatrix} = \begin{bmatrix} \cos(\Delta\phi / 2) & -\sin(\Delta\phi / 2) \\ -\sin(\Delta\phi / 2) & \cos(\Delta\phi / 2) \end{bmatrix} \begin{bmatrix} I \\ Q \end{bmatrix}$$

oder einer Näherung dieser Gleichung, wobei I und Q die Phasenfehler-behafteten I- und Q-Signalkomponenten, $I(\Delta\phi)$ und $Q(\Delta\phi)$ die Phasenfehler-kompensierten I- und Q-Signalkomponenten und $\Delta\phi$ der für die Korrektur verwendete Phasenfehler sind.

Durch die in dieser Gleichung angegebene Rotationsmatrix wird eine Phasendifferenz von 90° + $\Delta\phi$ auf rechnerischem Wege in die gewünschte Phasendifferenz von 90° transformiert.

Da in der Regel nur Phasenfehler $\Delta\phi < 10°$ zu berücksichtigen sind, wird eine implementierungsgünstigere Verfahrensvariante durch die in Anspruch 3 angegebene approximative Berechnung erreicht. Der Vorteil liegt daran, dass eine Berechnung der Winkelfunktionen cos($\cdot$) bzw. sin($\cdot$) entfällt.

Die Ermittlung des für die Korrektur verwendeten Phasenfehlers $\Delta\phi$ kann auf verschiedene Weise erfolgen. Nach einer ersten vorteilhaften Ausgestaltung des erfindungsgemäßen Verfahrens kann der Ermittlung des Phasenfehlers $\Delta\phi$ ein statistisches Verfahren, basierend auf Messungen der Phasenfehler einer Vielzahl von Hochfrequenzsendestufen bzw. Hochfrequenzempfangsstufen, zugrundeliegen. Beispielsweise wird der Phasenfehler $\Delta\phi$ als Mittelwert sämtlicher gemeseener Phasenfehler einer bestimmten Menge (z.B. Liefermenge oder Charge) von Hochfrequenzempfangsatufen oder Hochfrequenzsendestufen für den Bau von Empfangs- bzw. Sendesystemen mit der erfindungsgemäßen Korrekturmöglichkeit ermittelt. Diese Vorgehensweise ist vorteilhaft, wenn bei der Herstellung oder Montage der Hochfrequenzempfangsstufen bzw. Hochfrequenzsendestufen eine systematische mittlere Abweichung von der gewünschten 90°-Phasendifferenz zwischen dem I- und Q-Signalverarbeitungszweig auftritt und die Standardabweichung der entsprechenden Verteilung verhältnismäßig klein ist.

Eine andere, ebenfalls bevorzugte Ausgestaltung des erfindungsgemäßen Verfahrens kennzeichnet sich durch die Ermittlung eines Wertes für den für die Korrektur verwendeten Phasenfehler $\Delta\phi$ durch eine Messung des Phasenfehlers bei einer bestimmten Hochfrequenzsendestufe bzw. Hochfrequenzempfangsstufe. Auf diese Weise wird in jedem Sende- bzw. Empfangssystem eine gezielte und individuelle Einzelkorrektur des Phasenfehlers vorgenommen.

Vorzugsweise wird das erfindungsgemäße Kompensationsverfahren für Mobilfunkempfänger eingesetzt.

Die Erfindung wird nachfolgend anhand von Ausführungsbeispielen unter Bezugnahme auf die Zeichnung näher erläutert; in dieser zeigt:

Fig. 1    ein Blockschaltbild einer Sendeeinrichtung einer Mobilstation nach dem Stand der Technik;

Fig. 2    ein Blockschaltbild einer Empfangseinrichtung einer Mobilstation nach dem Stand der Technik;

Fig. 3    eine Darstellung eines äquivalenten Basisbandsignals in der komplexen Ebene für einen Phasenfehler $\Delta\phi = 0°$;

Fig. 4    eine Darstellung des äquivalenten Basisbandsignals in der komplexen Ebene für einen Phasenfehler $\Delta\phi = 5°$;

Fig. 5    ein Blockschaltbild einer erfindungsgemäßen Sendeeinrichtung mit digitaler Phasenkorrektur;

Fig. 6    ein Blockschaltbild einer erfindungsgemäßen Empfangseinrichtung mit digitaler Phasenkorrektur; und

Fig. 7    das Basisbandsignal für einen Phasenfehler $\Delta\phi = 5°$ nach der erfindungsgemäßen Phasenkorrektur.

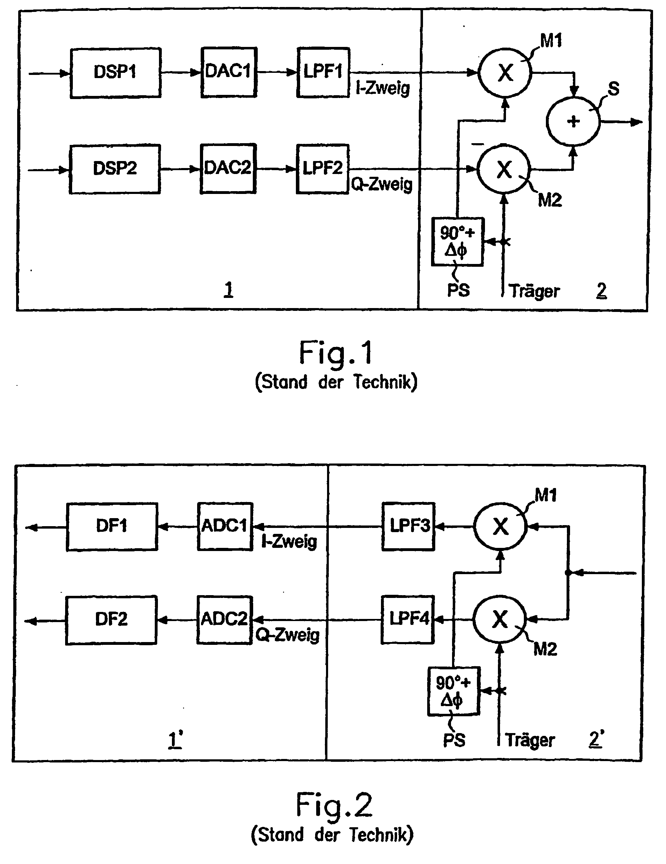

Fig. 1 zeigt den Signalverarbeitungspfad einer herkömmlichen Sendeeinrichtung, welche beispielsweise in Mobiltelefonen Anwendung findet. Unter Implementierungsgesichtspunkten setzt sich der Sendesignalpfad aus einem ersten Abschnitt 1, welcher in Form eines Basisband-Chips realisiert ist, und einem zweiten Abschnitt 2, welcher in Form eines Hochfrequenz-Chips vorliegt, zusammen.

Ein auf eine Datenquelle (z.B. Sprache) zurückgehendes, bereits moduliertes Datensignal wird mittels zweier digitaler Signalprozessoren DSP1 und DSP2 getrennt für den I- und den Q-Zweig einer Signalvorverarbeitung (üblich sind Ratenkonvertierungs- und Interpolationsschritte) unterzogen. Die auf diese Weise erzeugten I- und Q-Signalkomponenten des modulierten Signals werden in Digital-zu-Analog Umsetzern DAC1 und DAC2 jeweils in analoge Basisbandsignale umgesetzt. An die Signalumsetzung schließt sich eine Tiefpassfilterung mittels der Tiefpassfilter LPF1 bzw. LPF2 an. Die modulierten, analogen und tiefpassgefilterten I- und Q-Signalkomponenten werden über das sogenannte I/Q-Interface zur Trägersignalumsetzung in den Hochfrequenz-Signalverarbeitungsabschnitt 2 eingegeben. Die Trägersignalumsetzung geschieht dort durch das Hochmischen der analogen I- und Q-Signalkomponenten in Mischern M1 und M2 unter Verwendung von zwei idealerweise um 90° phasenverschobenen Trägern. Die in den Mischern M1 und M2 erzeugten modulierten Trägersignale werden in einer Summationsstufe S einander überlagert und als Hochfrequenzsignal über eine Antenne (nicht dargestellt) abgestrahlt.

Die in Fig. 2 gezeigte herkömmliche Empfangseinrichtung führt im wesentlichen eine inverse Signalverarbeitung durch. Unter Implementierungsaspekten kann die Empfangseinrichtung in denselben beiden Chips (HF-Chip und Basisband-Chip) wie die Sendeeinrichtung realisiert sein, wobei in Fig. 2 die entsprechenden Signalverarbeitungsabschnitte 1' und 2' des Empfangspfads innerhalb der jeweiligen Chips dargestellt sind.

Dieselben oder vergleichbare Teile wie In Fig. 1 werden in Fig. 2 mit denselben Bezugszeichen bezeichnet. Das über eine (nicht dargestellte) Antenne empfangene modulierte Trägersignal wird mittels der Mischer M1 und M2 in das Basisband oder auf eine Zwischenfrequenzlage heruntergemischt. Die M ischer M1, M2 werden zu diesem Zweck wiederum durch zwei orthogonale Träger betrieben, welche mittels eines Phasenschiebers PS aus einem einzigen Träger generiert werden. Die von dem Phasenschieber PS bewirkte Phasenverschiebung beträgt auch hier im Idealfall 90°.

Die von den Mischern M1 und M2 erzeugten I- und Q-Signalkomponenten werden in analogen Tiefpassfiltern LPF3, LPF4 jeweils einer Tiefpassfilterung unterzogen und anschließend über die I/Q-Schnittstelle (durch die in Fig. 2 dargestellte Trennlinie zwischen den Abschnitten 1' und 2' angedeutet) dem Signalverarbeitungsabschnitt 1' im Basisband-Chip zugeleitet. Dort werden die I-Signalkomponente mittels eines Analog-zu-Digital Umsetzers ADC1 und die Q-Signalkomponente mittels eines Analog-zu-Digital Umsetzers ADC2 in Digitalsignale umgesetzt. Eine weitere Kanalfilterung wird durch zwei separate digitale Filter DF1 und DF2 gewährleistet.

Weicht die Phasendifferenz der zwei den Mischstufen M1, M2 zugeordneten Trägern um einen Betrag $\Delta\phi$ von der gewünschten 90°-Phasendifferenz ab, so ergibt sich eine resultierende Phasendifferenz von 90° + $\Delta\phi$ beim Herauf- bzw. Heruntermischen des Sende- bzw. Empfangssignals. $\Delta\phi$ wird dabei als Phasenfehler bezeichnet. Der Phasenfehler $\Delta\phi$ kann durch den Phasenschieber PS, aber auch durch andere nicht dargestellte Signalverarbeitungselemente oder Einflußgrößen in den dargestellten Sende- bzw. Empfangseinrichtungen hervorgerufen werden.

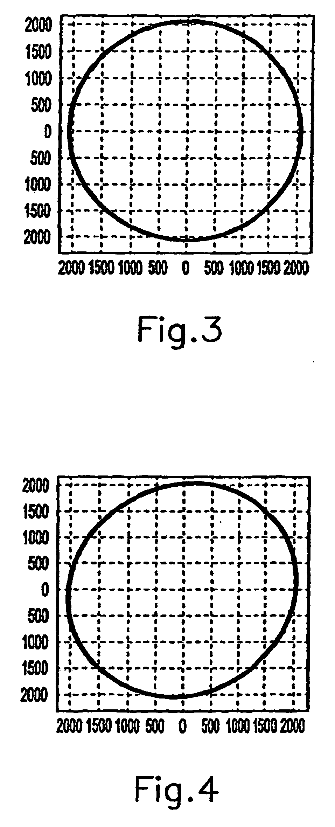

In Fig. 3 ist für ein reines Sinusträgersignal die I-Signalkomponente über der Q-Signalkomponente für den Fall $\Delta\phi$ = 0° aufgetragen. Es werden beliebige Einheiten verwendet. Ohne Phasenfehler wird das Sinusträgersignal exakt auf einen komplexen Sinus (Einheitskreis) abgebildet, siehe, Fig. 3.

Fig. 4 zeigt eine der Fig. 3 entsprechende Darstellung bei einem Phasenfehler $\Delta\phi$ = 5°. Aufgrund der jetzt nicht mehr vorhandenen Orthogonalität der Trägersignale erhält man für die I- und Q-Signalkomponenten gegenseitige Störanteile, die zu einer Verformung des Signals führen, welche sich in einer Abweichung von der Kreisform bemerkbar macht.

Wie bereits erwähnt, wirkt sich eine derartige Signal störung sowohl in der Sende- als auch der Empfangsrichtung nachteilig auf das Gesamtübertragungsverhalten aus. Ein Phasenfehler $\Delta\phi$ in Empfangsrichtung verursacht eine Störung des Empfangssignals, welcher zu einer Erhöhung der Bit-Fehlerrate (bei festem Signal-zu-Rausch-Verhältnis) führt. In der Sendeeinrichtung wird die Reinheit des Sendesignals durch die dargestellte Verzerrung beeinträchtigt.

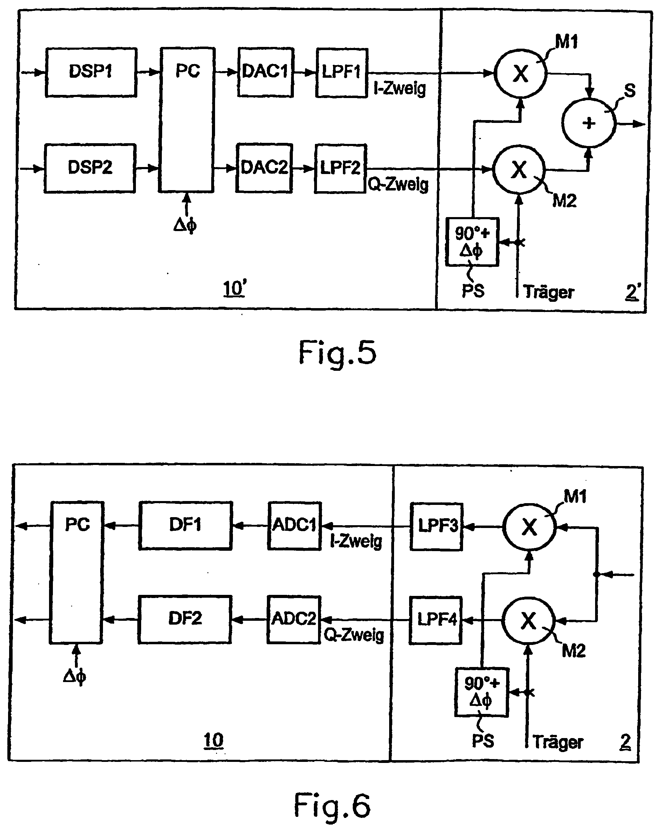

Die Fig. 5 und 6 zeigen Sende- bzw. Empfangseinrichtungen, in welchen auf erfindungsgemäße Weise eine Korrektur des Phasenfehlers im digitalen Signalverarbeitungsbereich vorgenommen wird. Zur Vermeidung von Wiederholungen bei der Beschreibung der erfindungsgemäßen Ausführungsbeispiele wird auf die Beschreibung zu den Fig. 1 und 2 verwiesen, welche für die erfindungsgemäßen Ausführungsbeispiele gültig bleibt. Der wesentliche Unterschied zwischen den in den Fig. 1 und 5 dargestellten Sendeeinrichtungen besteht darin, dass in den Signalwegen zwischen den digitalen Signalprozessoren DSP1, DSP2 und den Digital-zu-Analog-Umsetzem DAC1, DAC2 eine Phasenkorrekturstufe PC vorgesehen ist. Der entsprechende Signalverarbeitungsabschnitt im Basisband-Chip wird mit dem Bezugszeichen 10' bezeichnet. In analoger Weise besteht der wesentliche Unterschied zwischen den in der Fig. 2 und der Fig. 6 dargestellten Empfangseinrichtungen darin, dass sich vorzugsweise im Signalweg hinter den digitalen Filtern DF1, DF2 eine Phasenkorrekturstufe PC anschließt, wobei hier der geänderte Signalverarbeitungsabschnitt im Basisband mit dem Bezugszeichen 10 bezeichnet ist.

Die in den Signalverarbeitungsabschnitten 10 und 10' verwendeten Phasenkorrekturstufen PC können baugleich sein. Im folgenden wird ihre Wirkungsweise erläutert:

Ein im äquivalenten Basisband vorhandener Phasenfehler kann durch die folgende Matrizenoperation model-liert werden:

$$\begin{bmatrix} I \\ Q \end{bmatrix} = \begin{bmatrix} \cos(\Delta\phi\ /\ 2) & \sin(\Delta\phi\ /\ 2) \\ \sin(\Delta\phi\ /\ 2) & \cos(\Delta\phi\ /\ 2) \end{bmatrix} \begin{bmatrix} I_0 \\ Q_0 \end{bmatrix}$$

Dabei bezeichnen $I_0$ und $Q_0$ Trägersignale mit der optimalen Phasendifferenz von 90°, und I und Q bezeichnen die Phasenfehler-behafteten I- und Q-Signalkomponenten.

Dieser Phasenfehler $\Delta\phi$ wird nun im Empfangspfad und/oder auch im Sendepfad durch die folgende Matrizenoperation idealerweise wieder vollständig rückgängig gemacht.

$$\begin{bmatrix} I(\Delta\phi) \\ Q(\Delta\phi) \end{bmatrix} = \begin{bmatrix} \cos(\Delta\phi/2) & -\sin(\Delta\phi/2) \\ -\sin(\Delta\phi/2) & \cos(\Delta\phi/2) \end{bmatrix} \begin{bmatrix} I \\ Q \end{bmatrix}$$

Diese Berechnungsvorschrift wird von der Phasenkorrekturstufe PC ausgeführt. Eine (theoretisch) exakte Korrektur des Phasenfehlers ist In den meisten Fällen jedoch nicht erforderlich. Durch Anwendung einer approximierten Derotationsmatrix gemäß der Gleichung

$$\begin{bmatrix} I(\Delta\phi) \\ Q(\Delta\phi) \end{bmatrix} = \begin{bmatrix} 1 - \Delta\phi/2 & -\Delta\phi/2 \\ -\Delta\phi/2 & 1 - \Delta\phi/2 \end{bmatrix} \begin{bmatrix} I \\ Q \end{bmatrix}$$

wird eine digitale Phasenkorrektur mit wesentlich geringerem Rechenaufwand realisiert. Dies gilt sowohl für die Phasenkorrekturatufe PC in der Sendeeinrichtung als auch für die Phasenkorrekturstufe PC in der Empfangseinrichtung.

Die Bestimmung des in der Phasenkorrekturstufe PC anzuwendenden Phasenfehlers $\Delta\phi$ kann auf verschiedene Weise erfolgen. Eine erste Möglichkeit besteht darin, dass der zu korrigierend Phasenfehfer $\Delta\phi$ einmalig bestimmt und im Rahmen der Erstmontage des Gerätes in die Phasenkorrekturstufe PC einprogrammiert wird. Das Gerät ist dann für den weiteren Betrieb Phasenfehler-kompensiert. Die Bestimmung des Phasenfehlers $\Delta\phi$ kann dabei gerätebezogen durch eine Messung des in dem jeweiligen Gerät tatsächlich auftretenden Phasenfehlers $\Delta\phi$ oder auch auf statistische Weise anhand einer Messung der Phasenfehler einer Vielzahl von Geräten gleicher Bauart oder Serie ermittelt werden.

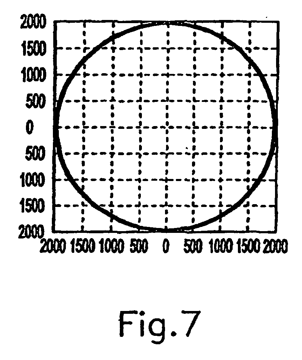

Fig. 7 zeigt eine den Fig. 3 und 4 vergleichbare Darstellung der Phasenbeziehung zwischen der **I**- und der Q-Signalkomponente des Basisbandsignals nach Vorname einer erfindungsgemäßen Phasenfehlerkompensation. Der Darstellung liegt ein Basisbandsignal mit einem Phasenfehler von $\Delta\phi = 5°$ zugrunde, wie es ohne verwendung der erfindungsgemäßen Phasenfehler-Kompensationsstufe PC in Fig. 4 dargestellt ist. Ein Unterschied zum idealen komplexen Sinus-Signal mit einer Phasendifferenz von exakt 90° ist nicht zu erkennen, vergleiche Fig. 3.

**Patentansprüche**

1.  Verfahren zur Kompensation eines Phasenfehlers in einem Sendesystem mit I- und Q-Signalverarbeitungszweigen, **gekennzeichnet durch** die Schritte:

- Programmieren eines zuvor **durch** Messung ermittelten Phasenfehlers $\Delta\phi$ einer in dem Sendesystem verwendeten Hochfrequenzsendestufe während der Erstmontage des Sendesystems in den digitalen Signalverarbeitungsabschnitt des Sendesystems; und
- Berechnen von phasenkorrigierten I- und Q-Signalkomponenten in einem digitalen Signalverarbeitungsabschnitt der I- und Q-Signalverarbeitungszweige während des Sendebetriebs **durch** Korrektur von I- und Q-Signalkomponenten mit dem programmierten konstanten Phasenfehler $\Delta\phi$.

2.  verfahren zur Kompensation eines Phasenfehlers in einem Empfangssystem mit I- und Q-Signalverarbeitungszweigen, **gekennzeichnet durch** die Schritte:

- Programmieren eines zuvor **durch** Messung ermittelten Phasenfehlers $\Delta\phi$ einer in dem Empfangssystem verwendeten Hochfrequenzempfangsstufe während der Erstmontage des Empfangssystems in den digitalen Signalverarbeitungsabschnitt des Empfangssystems; und
- Berechnen von phasenkorrigierten I- und Q-Signalkomponenten in einem digitalen Signalverarbeitungsabschnitt der I- und Q-Signalverarbeitungszweige des Empfangssystems während des Empfangsbetriebs **durch** Korrektur von Phasenfehler-behafteten I- und Q-Signalkomponenten mit dem programmierten konstanten Phasenfehler $\Delta\phi$.

3.  Verfahren nach Anspruch 1 oder 2, **dadurch gekennzeichnet,** **dass** die Berechnung gemäß

$$\begin{bmatrix} I(\Delta\phi) \\ Q(\Delta\phi) \end{bmatrix} = \begin{bmatrix} \cos(\Delta\phi/2) & -\sin(\Delta\phi/2) \\ -\sin(\Delta\phi/2) & \cos(\Delta\phi/2) \end{bmatrix} \begin{bmatrix} I \\ Q \end{bmatrix}$$

oder einer Näherung dieser Gleichung erfolgt, wobei I und Q die Phasenfehler-behafteten I- und Q-Signalkomponenten, I($\Delta\phi$) und Q($\Delta\phi$) die Phasenfehler-kompensierten I- und Q-Signalkomponenten und $\Delta\phi$ der für die Korrektur verwendete Phasenfehler ist.

4. Verfahren nach Anspruch 3,
**dadurch gekennzeichnet,**
**dass** die Berechnung gemäß

$$\begin{bmatrix} I(\Delta\phi) \\ Q(\Delta\phi) \end{bmatrix} = \begin{bmatrix} 1 - \Delta\phi/2 & -\Delta\phi/2 \\ -\Delta\phi/2 & 1 - \Delta\phi/2 \end{bmatrix} \begin{bmatrix} I \\ Q \end{bmatrix}$$

erfolgt.

5. Verfahren nach einem der vorhergehenden Ansprüche, **gekennzeichnet durch** den Schritt:

- Ermitteln eines Wertes für den für die Korrektur verwendeten Phasenfehler $\Delta\phi$ **durch** ein statistisches Verfahren basierend auf Messungen der Phasenfehler einer Vielzahl von Hochfrequenzsendestufen bzw. Hochfrequenzempfangsstufen.

6. Verfahren nach einem der vorhergehenden Ansprüche, **gekennzeichnet durch** den Schritt:

- Ermitteln eines Wertes für den für die Korrektur verwendeten Phasenfehler $\Delta\phi$ **durch** eine Messung des Phasenfehlers einer bestimmten Hochfrequenzsendestufe bzw. Hochfrequenzempfangsstufe.


**Claims**

1. Method for compensating for a phase error in a transmission system having I and Q signal processing paths, **characterized by** the following steps:

- a phase error $\Delta\phi$, previously ascertained by measurement, in a radio frequency transmission stage used in the transmission system is programmed into the digital signal processing section of the transmission system when the transmission system is first fitted; and
- phase corrected I and Q signal components are computed in a digital signal processing section of the I and Q signal processing paths during transmission mode by correcting I and Q signal components with the programmed constant phase error $\Delta\phi$.

2. Method for compensating for a phase error in a reception system having I and Q signal processing paths, **characterized by** the following steps:

- a phase error $\Delta\phi$, previously ascertained by measurement, in a radio frequency reception stage used in the reception system is programmed into the digital signal processing section of the reception system when the reception system is first fitted; and
- phase corrected I and Q signal components are computed in a digital signal processing section of the I and Q signal processing paths of the reception system during reception mode by correcting I and Q signal components containing phase errors with the programmed constant phase error $\Delta\phi$.

3. Method according to Claim 1 or 2,
**characterized in that** the computation is performed on the basis of

$$\begin{bmatrix} I(\Delta\phi) \\ Q(\Delta\phi) \end{bmatrix} = \begin{bmatrix} \cos(\Delta\phi/2) & -\sin(\Delta\phi/2) \\ -\sin(\Delta\phi/2) & \cos(\Delta\phi/2) \end{bmatrix} \begin{bmatrix} I \\ Q \end{bmatrix}$$

or on the basis of an approximation of this equation, where I and Q are the I and Q signal components containing phase errors, I($\Delta\phi$) and Q($\Delta\phi$) are the phase error compensated I and Q signal components, and $\Delta\phi$ is the phase error used for the correction.

**4.** Method according to Claim 3,
**characterized in that** the computation is performed on the basis of

$$\begin{bmatrix} I(\Delta\phi) \\ Q(\Delta\phi) \end{bmatrix} = \begin{bmatrix} 1 - \Delta\phi/2 & -\Delta\phi/2 \\ -\Delta\phi/2 & 1 - \Delta\phi/2 \end{bmatrix} \begin{bmatrix} I \\ Q \end{bmatrix}.$$

**5.** Method according to one of the preceding claims, **characterized by** the following step:

- a value for the phase error $\Delta\phi$ used for the correction is ascertained using a statistical method based on measurements of the phase errors in a multiplicity of radio frequency transmission stages and radio frequency reception stages.

**6.** Method according to one of the preceding claims, **characterized by** the following steps:

- a value for the phase error $\Delta\phi$ used for the correction is ascertained by measuring the phase error in a particular radio frequency transmission stage or radio frequency reception stage.

**Revendications**

**1.** Procédé de compensation d'une erreur de phase dans un système d'émission avec branches de traitement de signal I et Q,
**caractérisé par** les étapes suivantes :

- programmation d'une erreur de phase $\Delta\phi$, préalablement déterminée par mesure, d'un étage d'émission à haute fréquence utilisé dans le système d'émission pendant le premier montage du système d'émission dans le tronçon de traitement de signal numérique du système d'émission ; et
- calcul des composantes de signal I et Q à phase corrigée dans un tronçon de traitement de signal numérique des branches de traitement de signal I et Q pendant le fonctionnement en émission par correction des composantes de signal I et Q avec l'erreur de phase $\Delta\phi$ constante programmée.

**2.** Procédé de compensation d'une erreur de phase dans un système de réception avec branches de traitement de signal I et Q,
**caractérisé par** les étapes suivantes :

- programmation d'une erreur de phase $\Delta\phi$, préalablement déterminée par mesure, d'un étage de réception à haute fréquence utilisé dans le système de réception pendant le premier montage du système de réception dans le tronçon de traitement de signal numérique du système de réception ; et
- calcul des composantes de signal I et Q à phase corrigée dans un tronçon de traitement de signal numérique des branches de traitement de signal I et Q du système de réception pendant le fonctionnement en réception par correction des composantes de signal I et Q entachées d'une erreur de phase avec l'erreur de phase $\Delta\phi$ constante programmée.

**3.** Procédé selon la revendication 1 ou 2,
**caractérisé par le fait que** le calcul s'effectue selon

$$\begin{bmatrix} I(\Delta\phi) \\ Q(\Delta\phi) \end{bmatrix} = \begin{bmatrix} \cos(\Delta\phi/2) & -\sin(\Delta\phi/2) \\ -\sin(\Delta\phi/2) & \cos(\Delta\phi/2) \end{bmatrix} \begin{bmatrix} I \\ Q \end{bmatrix}$$

ou selon une approximation de cette équation, I et Q étant les composantes de signal I et Q entachées d'une erreur de phase, I et $Q(\Delta\phi)$ étant les composantes de signal I et Q à erreur de phase compensée et $\Delta\phi$ étant l'erreur de phase utilisée pour la correction.

**4.** Procédé selon la revendication 3,
**caractérisé par le fait que** le calcul s'effectue selon

$$\begin{bmatrix} I(\Delta\phi) \\ Q(\Delta\phi) \end{bmatrix} = \begin{bmatrix} 1-\Delta\phi/2 & -\Delta\phi/2 \\ -\Delta\phi/2 & 1-\Delta\phi/2 \end{bmatrix} \begin{bmatrix} I \\ Q \end{bmatrix}$$

.

5. Procédé selon l'une des revendications précédentes, **caractérisé par** l'étape :

    détermination d'une valeur pour l'erreur de phase $\Delta\phi$ utilisée pour la correction par un procédé statistique basé sur des mesures des erreurs de phase de plusieurs étages d'émission à haute fréquence ou d'étages de réception à haute fréquence.

6. Procédé selon l'une des revendications précédentes, **caractérisé par** l'étape :

    détermination d'une valeur pour l'erreur de phase $\Delta\phi$ utilisée pour la correction par une mesure de l'erreur de phase d'un certain étage d'émission à haute fréquence ou d'un certain étage de réception à haute fréquence.

# Fig.1
(Stand der Technik)

# Fig.2
(Stand der Technik)

Fig.3

Fig.4

Fig.5

Fig.6

Fig.7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5705949 A

- EP 0378719 A